**Europäisches Patentamt**

**European Patent Office**

**Office européen des brevets**

(19)

(11) Veröffentlichungsnummer : **0 343 392 B1**

(12) # EUROPÄISCHE PATENTSCHRIFT

(45) Veröffentlichungstag der Patentschrift :
23.09.92 Patentblatt 92/39

(51) Int. Cl.⁵ : **G01R 15/02**

(21) Anmeldenummer : **89107538.4**

(22) Anmeldetag : **26.04.89**

(54) **Anordnung zum Nachbilden einer Wechselgrösse bei einem gesteuerten Halbleiter.**

(30) Priorität : **09.05.88 DE 3815849**

(43) Veröffentlichungstag der Anmeldung :
**29.11.89 Patentblatt 89/48**

(45) Bekanntmachung des Hinweises auf die
Patenterteilung :
**23.09.92 Patentblatt 92/39**

(84) Benannte Vertragsstaaten :
**CH DE FR GB LI SE**

(56) Entgegenhaltungen :
**DE-A- 3 704 565**

(56) Entgegenhaltungen :
GB-A- 2 016 827
US-A- 4 255 704
**HEWLETT-PACKARD JOURNAL, Band 28, Nr.
6, Februar 1977, Seiten 11-19; J.E. McDERMID
et al.: "A high-speed system voltmeter fort-
ime-related measurements"**

(73) Patentinhaber : **SIEMENS
AKTIENGESELLSCHAFT
Wittelsbacherplatz 2
W-8000 München 2 (DE)**

(72) Erfinder : **Pereira, Marcos A.C.
Sperlingstrasse 21
W-8520 Erlangen (DE)**

EP 0 343 392 B1

**Beschreibung**

Die Erfindung betrifft eine Anordnung zum Nachbilden einer Wechselgröße, die eine Gleichkomponente aufweist, insbesondere eines Wechselstromes, bei einem gesteuerten Halbleiter-Bauelement mit einem elektromagnetischen Wandler für Meßzwecke.

Beim Übertragen einer Wechselgröße mittels eines elektromagnetischen Wandlers wird eine stationäre Gleichkomponente nicht übertragen. Die Folge ist eine Nullpunktsverschiebung der vom Wandler abgegebenen Wechselgröße gegenüber der Eingangswechselgröße. Diese Problematik tritt insbesondere bei der Messung von Strömen bei gesteuerten Halbleiter-Bauelementen auf. Es kann z.B. eine Gleichkomponente im Stromverlauf eines Thyristorstellers durch ungleiche Zündwinkel für die einzelnen Thyristoren auftreten. Da die gemessene Wechselgröße für die Thyristorsteuerung benötigt wird, ist es besonders wichtig, einen unverfälschten Wert zu erhalten.

Dazu wurden bisher Einrichtungen eingesetzt, (vge. z.B. US-A-4255704), die infolge besonderer Vorkehrungen eine Gleichkomponente übertragen können. Diese Einrichtungen enthalten z.B. Wandler mit einer besonderen Zusatzwicklung, über die eine Vormagnetisierung des Wandlerkerns bewirkt wird, die der Magnetisierung infolge der Gleichkomponente entgegenwirkt. Solche Wandler sind aufwendig. Außerdem sind hierbei zusätzliche Regeleinrichtungen für die Vormagnetisierung erforderlich.

Der Erfindung liegt die Aufgabe zugrunde, eine Anordnung der eingangs genannten Art anzugegeben, mit der bei einem gesteuerten Halbleiter-Bauelement die elekrische Wechselgröße mit Gleichkomponente auf einfache Art für Meß-, Regel- und Steuerfunktionen nachgebildet werden kann.

Diese Aufgabe wird bei einer Anordnung der eingangs genannten Art erfindungsgemäß dadurch gelöst, daß eine Sekundärwicklung des Wandlers mit einem Eingang eines Sample & Hold-Gliedes verbunden ist, dessen Triggereingang an eine Steuereinrichtung für das Halbleiter-Bauelement angeschlossen ist und von dieser Steuereinrichtung Triggerimpulse jeweils zu den Steuerzeitpunkten des Halbleiter-Bauelementes erhält, und daß der Ausgang des Sample & Hold-Gliedes, dessen Ausgangssignal proportional der Gleichkomponente ist, auf einen ersten Eingang eines Vergleichers geführt ist, dessen zweiter Eingang mit der Sekundärwicklung des Wandlers verbunden ist und an dessen Ausgang die nachgebildete Wechselgröße abgreifbar ist.

Auf diese Weise wird mit einfachen Mitteln eine Nachbildung der benötigten elektrischen Wechselgröße samt Gleichkomponente erreicht. Es können herkömmliche kostengünstige Wandler, z.B. übliche Schutzwandler, für die Meßwerterfassung eingesetzt werden. Diese tragen zudem durch ihre geringe Baugröße zu einer wesentlichen Verringerung des Platzbedarfs gegenüber der herkömmlichen Lösung mit Zusatzwicklung bei. Mit der vorliegenden Anordnung ist es möglich, sehr kleine Gleichstromkomponenten zu erfassen. Dabei werden nur die Gleichstromkomponenten berücksichtigt, die stationär sind und nicht vom Wandler übertragen werden.

Es ist günstig, den Vergleicher als Subtrahierer auszubilden, wobei der erste Eingang als invertierender und der zweite Eingang als nicht-invertierender Eingang ausgebildet sind. Auf diese Weise entspricht die nachgebildete Wechselgröße (Gleich- und Wechselkomponente) auch in ihrer Phasenlage der ursprünglichen Wechselgröße. Dieser Vorteil ist ebenfalls bei einer Ausführung gegeben, bei der der Vergleicher als Summierglied aus gebildet und zwischen dem Sample & Hold-Glied und dem Vergleicher ein Invertierglied angeordnet ist.

Vorzugsweise sind das Invertierglied und/oder der Vergleicher als Verstärker ausgebildet. Damit kann eine Anpassung der Pegelverhältnisse zwischen dem Wandler und den nachfolgenden Gliedern erzielt werden, wodurch die Erfassung auch sehr kleine Gleichkomponenten möglich ist.

Nach einer vorteilhaften Ausgestaltung ist zwischen dem Ausgang des Vergleichers und einem Meßausgang eine Filteranordnung angeordnet, die als Sperr- und Tiefpaß-Filter ausgebildet ist. So steht am Meßausgang die gesamte in der Wechselgröße enthaltene Gleichkomponente für weitere Zwecke zur Verfügung. Dieses Meßsignal kann mit Vorteil dazu dienen, über die Steuereinrichtung eine Ausregelung der unerwünschten Gleichkomponente zu erzielen.

Weitere vorteilhafte Ausgestaltungen sind in den Unteransprüchen angegeben.

Ausführungsbeispiele der erfindungsgemäßen Anordnung werden anhand der Zeichnung im folgenden näher erläutert. Es zeigen:

FIG 1 eine erste Anordnung zum Nachbilden des Wechselstromes an einem Thyristor-Stellglied und
FIG 2 eine zweite solche Anordnung.

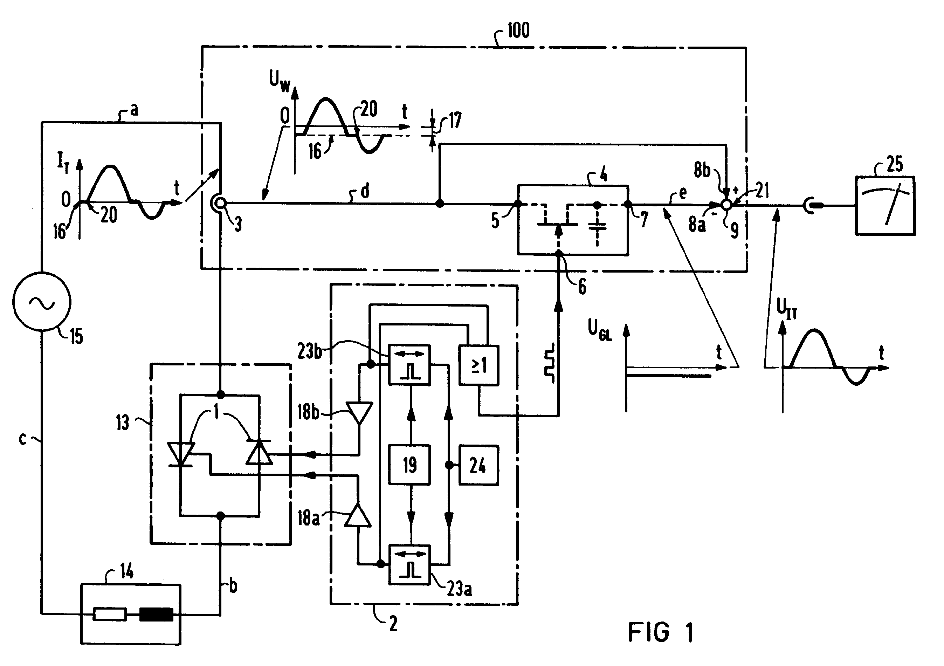

In FIG 1 ist eine Anordnung 100 zum Nachbilden einer Wechselgröße bei einem gesteuerten Halbleiter-Bauelement, insbesondere einem Thyristor,gezeigt. Dieser ist Bestandteil eines Thyristor-Stellgliedes 13, das mit Leitungen a, b, c, einer Last 14 und einer Spannungsquelle 15 einen Stromkreis bildet. Durch das Stellglied 13 fließt ein Strom $I_T$ wie dargestellt. Dabei ist zu beachten, daß die beiden Halbwellen aufgrund ungleicher Zündwinkel unterschiedliche Größe haben und der Stromverlauf daher eine Gleichkomponente aufweist. Diese soll stationär sein. Die Halbleiter-Bauelemente 1 des Stellgliedes 13 erhalten ihre Steuerimpulse aus einer Steuereinrichtung 2. Diese Steuereinrichtung 2 beinhaltet einen Impulsgenerator 24, dessen Ausgangsimpulse über Winkelsteuerungen 23a, 23b und Anpassungsstufen 18a, 18b an die gesteuerten Halbleiter 1 weitergeben werden. Der Strom $I_T$ wird von einem Wandler 3 erfaßt. Durch die Übertragungseigenschaften des Wandlers 3 wird auf seine Sekundärseite auf der Leitung d eine Spannung $U_W$ wie dargestellt übertragen. Man erkennt, daß die Gleichkomponente vom Wandler 3 unterdrückt ist. Die Spannungszeitflächen der zueinander zugehörigen positiven und negativen Halbwellen sind gleich groß. Die ursprüngliche Nullinie 16 des Stromverlaufs $I_T$ ist um den Betrag 17 der Gleichkomponente nach unten verschoben. Diese Spannung $U_W$ wird über Leitung d auf einen Eingang 5 eines Sample & Hold-Gliedes 4 gegeben, dessen Triggereingang 6 mit der Steuereinrichtung 2 gekoppelt ist. Von der Steuereinrichtung 2 erhält das Sample & Hold-Glied 4 Triggerimpule jeweils zu den Steuerzeitpunkten 20 der Halbleiter-Bauelemente 1. Dadurch wird erzielt, daß jeweils zu den Steuerzeitpunkten 20 der Halbleiter-Bauelemente 1 die Spannung $U_W$ abgetastet wird und dieser Wert solange am Ausgang 7 des Sample & Hold-Gliedes 4 ausgegeben wird, bis ein nächster Triggerimpuls folgt. Zum Steuerzeitpunkt 20 ist der Strom $I_T$ der Halbleiter-Bauelemente 1 Null. Betrachtet man zu diesen Zeitpunkten 20 den Wert der Spannung $U_W$, so erhält man genau mit dem Betrag 17 den Anteil der Gleichkomponente. Das Ausgangssignal $U_{GL}$ auf Leitung e des Sample & Hold-Gliedes 4 ist also proportional der Gleichkomponente. Der Ausgang 7 ist mit einem ersten Eingang 8a eines Vergleichers 9 verbunden, dessen zweiter Eingang 8b mit der Sekundärwicklung des Wandlers 3 verbunden ist. Dabei ist es günstig, daß der Vergleicher 9 als Subtrahierer ausgebildet ist, wobei der erste Eingang 8a als invertierender und der zweite Eingang 8b als nicht-invertierender Eingang ausgebildet sind. Das bedeutet, daß die Gleichkomponente $U_{GL}$ von der Wechselgröße $U_W$ subtrahiert wird. Am Ausgang 21 des Vergleichers 9 steht so die phasenrichtige Nachbildung $U_{IT}$ der ursprünglichen Wechselgröße $I_T$ an. Das Signal $U_{IT}$ wird dann für weitere Meßzwecke verwendet. Es kann z.B. an Temperaturüberwachungen, Überwachungs -und Regeleinrichtungen oder wie dargestellt, an eine Meßeinrichtung 25 weitergegeben werden, die den Stromwert anzeigt.

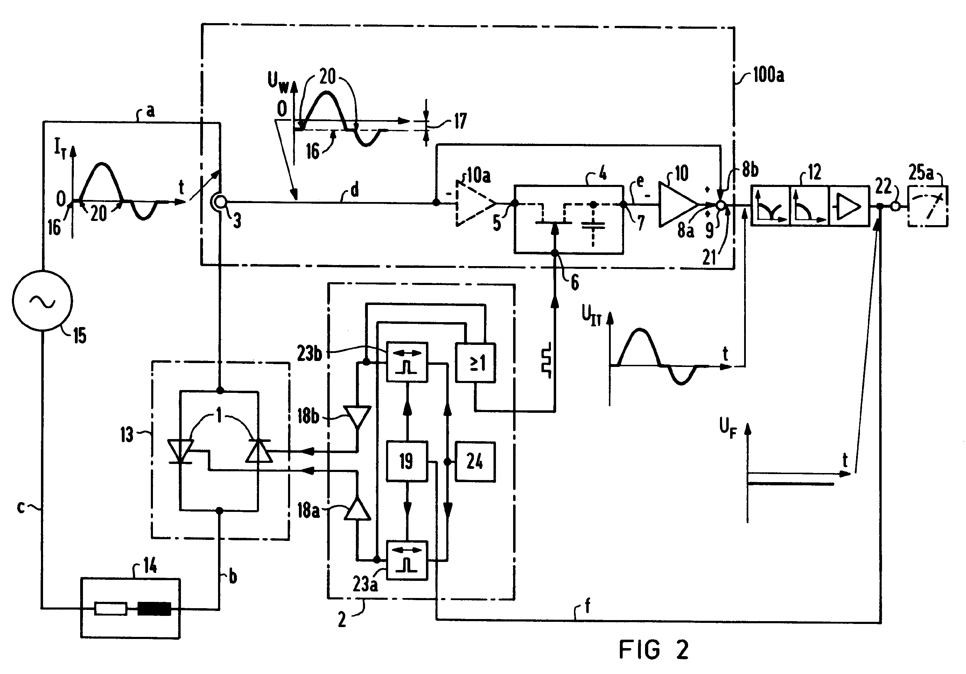

In FIG 2 ist ein weiteres Ausführungsbeispiel der dargestellt. Dabei ist der Vergleicher 9 als Summierglied ausgebildet. Damit die Gleichkomponente mit der richtigen Polarität mit dem Wandlersignal summiert wird, ist zwischen dem Sample & Hold-Glied 4 und dem Vergleicher 9 ein Invertierglied 10 angeordnet. Alternativ kann auch ein Invertierglied 10a am Eingang des Sample & Hold-Gliedes 4 angeordnet sein. Das Invertierglied 10, 10a und/oder der Vergleicher 9 sind vorzugsweise als Verstärker ausgebildet, um eine optimale Anpassung der einzelnen Glieder aufeinander zu erzielen.

Zwischem dem Ausgang 21 des Vergleichers 9 und einem Meßausgang 22 ist ein Filter 12 angeordnet, das als Sperr- und Tiefpassfilter ausgebildet ist. Durch das Filter 12 werden alle Wechselanteile der Spannung $U_{IT}$ eliminiert, so daß am Meßausgang 22 eine Spannung $U_F$ ansteht, die der gesamten im Strom $I_T$ enthaltenen Gleichkomponente proportional ist. Diese kann beispielsweise über eine Leitung f auf ein Steuergerät 19 der Steuereinrichtung 2 geführt werden, um durch eine Korrektur der Steuerzeitpunkte eine unerwünschte Gleichkomponente im Laststromkreis zu erzielen. Dies ist von besonderer Bedeutung, wenn die Last 14 induktiv ist und eine unerwünschte Vormagnetisierung auftritt. Die Spannung $U_F$ dient als ein Maß für die Vormagnetisierung. Alternativ kann die Spannung auch Überwachungseinrichtungen oder wie dargestellt, einer Meßeinrichtung 25a zugeführt werden.

Wesentlicher Vorteil der Anordnung 100 bzw. 100a ist, daß nur die Gleichkomponente von dem Sample & Hold-Glied 4 erfaßt wird, die von dem Wandler 3 nicht übertragen wird. Das heißt, daß z.B. kurzzeitig dynamisch auftretende Komponenten, die der Wandler 3 übertragen kann, von dem Sample & Hold-Glied 4 nicht erfaßt werden. Sie weisen im zeitlichen Verlauf im Gegensatz zum Signal $U_W$ keine Verschiebung der Wechselgröße auf der Sekundärseite des Wandlers 3 auf. Dynamische Komponenten werden also speziell berücksichtigt und können gegebenenfalls in der Filteranordnung 12 weiter behandelt werden.

**Patentansprüche**

1. Anordnung zum Nachbilden einer Wechselgröße, die eine Gleichkomponente aufweist, insbesondere eines Wechselstromes, bei einem gesteuerten Halbleiter -Bauelement (1) mit einem elektromagnetischen Wandler (3) für Meßzwecke, **dadurch gekennzeichnet,** daß eine Sekundärwicklung des Wandlers (3) mit einem Eingang (5) eines Sample & Hold-Gliedes (4) verbunden ist, dessen Triggereingang (6) an eine Steuereinrichtung (2) für das Halbleiter-Bauelement (1) angeschlossen ist und von dieser Steuereinrichtung (2) Triggerimpulse jeweils zu den Steuerzeitpunkten (20) des Halbleiter-Bauelementes (1) erhält, und daß der Ausgang (7) des Sample & Hold-Gliedes (4), dessen Ausgangssignal proportional der Gleichkomponente ist, auf einen ersten Eingang (8a) eines Vergleichers (9) geführt ist, dessen zweiter Eingang (8b) mit der Sekundärwicklung des Wandlers (3) verbunden ist und an dessen Ausgang (21) die nachgebildete Wechselgröße abgreifbar ist.

2. Anordnung nach Anspruch 1, **dadurch gekennzeichnet,** daß der Vergleicher (9) als Subtrahierer mit einem ersten und zweiten Eingang ausgebildet ist, und daß der erste Eingang (8a) als invertierender und der zweite Eingang (8b) als nicht-invertierender Eingang ausgebildet sind.

3. Anordnung nach Anspruch 1, **dadurch gekennzeichnet,** daß der Vergleicher (9) als Summierglied ausgebildet ist, und daß zwischen dem Sample & Hold-Glied (4) und dem Vergleicher (9) ein Invertierglied (10) angeordnet ist.

4. Anordnung nach Anspruch 1, **dadurch gekennzeichnet,** daß der Vergleicher (9) als Summierglied ausgebildet ist, und daß ein Invertierglied (10a) am Eingang (5) des Sample & Hold-Gliedes (4) angeordnet ist.

5. Anordnung nach Anspruch 3 oder 4, **dadurch gekennzeichnet,** daß das Invertierglied (10, 10a) als Verstärker ausgebildet ist.

6. Anordnung nach einem der vorhergehenden Ansprüche, **dadurch gekennzeichnet,** daß zwischen dem Ausgang (21) des Vergleichers (9) und einem Meßausgang (22), an dem die nachgebildete Wechselgröße abgreifbar ist, ein Filter (12) angeordnet ist, das als Sperr- und Tiefpaßfilter ausgebidet ist.

7. Anordnung nach einem der vorhergehenden Ansprüche, **dadurch gekennzeichnet,** daß der Vergleicher (9) als Verstärker ausgebildet ist.

8. Anordnung nach einem der Ansprüche 1 bis 7, **dadurch gekennzeichnet,** daß das Halbleiter-Bauelement (1) mindestens einen Thyristor umfaßt.

9. Anordnung nach Anspruch 8, **dadurch gekennzeichnet,** daß das Halbleiter-Bauelement (1) Bestandteil eines Thyristor-Stellgliedes (13) ist.

10. Anordnung nach einem der Ansprüche 6 bis 9, **dadurch gekennzeichnet,** daß an dem Meßausgang (22) eine Meßeinrichtung (25, 25a) angeschlossen ist, die einen Stromwert anzeigt.

## Claims

1. Arrangement for the reproduction of an alternating quantity, which has a direct component, in particular of an alternating current in a controlled semiconductor component (1), with a measuring electromagnetic transformer (3), characterized in that a secondary winding of the transformer (3) is connected to an input (5) of a sample and hold circuit (4), the trigger input (6) of which is attached to a control device (2) for the semiconductor component (1) and from this control device (2) receives trigger pulses in each case at the control instants (20) of the semiconductor component (1), and in that the output (7) of the sample and hold circuit (4), the output signal of which is proportional to the direct component, is conducted to a first input (8a) of a comparator (9), the second input (8b) of which is connected to the secondary winding of the transformer (3) and at the output (21) of which the reproduced alternating quantity can be picked up.

2. Arrangement according to claim 1, characterized in that the comparator (9) is constructed as a subtractor with a first and second input, and in that the first input (8a) is constructed as an inverting input and the second input (8b) is constructed as a non-inverting input.

3. Arrangement according to claim 1, characterized in that the comparator (9) is constructed as a summing element and in that an inverting element (10) is arranged between the sample & hold element (4) and the comparator (9).

4. Arrangement according to claim 1, characterized in that the comparator (9) is constructed as a summing element, and in that an inverting element (10a) is arranged at the input (5) of the sample & hold element (4).

5. Arrangement according to claim 3 or 4, characterized in that the inverting element (10, 10a) is constructed as an amplifier.

6. Arrangement according to one of the preceding claims, characterized in that between the output (21) of the comparator (9) and a measuring output (22), at which the reproduced alternating quantity can be picked up, a filter (12) is arranged, which is constructed as a blocking and low-pass filter.

7. Arrangement according to one of the preceding claims, characterized in that the comparator (9) is constructed as an amplifier.

8. Arrangement according to one of claims 1 to 7, characterized in that the semiconductor component (1) comprises at least one thyristor.

9. Arrangement according to claim 8, characterized in that the semiconductor component (1) is a component of a thyristor control device (13).

10. Arrangement according to one of claims 6 to 9, characterized in that a measuring device (25, 25a) is attached to the measuring output (22), which measuring device displays a current value.


**Revendications**

1. Dispositif pour reproduire une grandeur alternative qui possède une composante continue, notamment un courant alternatif, dans un composant à semiconducteurs (1) commandé, comportant un transducteur électromagnétique (3) pour réaliser des mesures, caractérisé par le fait qu'un enroulement secondaire du transducteur (3) est raccordé à une entrée (5) d'un circuit Sample & Hold (échantillonnage et blocage) (4), dont l'entrée de déclenchement (6) est raccordée à un dispositif de commande (2) pour le composant à semiconducteurs (1) et reçoit, de la part de ce dispositif de commande (2), des impulsions de déclenchement respectivement aux instants de commande (20) du composant à semiconducteurs (1), et que la sortie (7) du circuit Sample & Hold (4), dont le signal de sortie est proportionnel à la composante continue, est envoyée à une entrée (8a) d'un comparateur (9), dont la seconde entrée (8b) est raccordée à l'enroulement secondaire du transducteur (3) et à la sortie (21) duquel la grandeur alternative reproduite peut être prélevée.

2. Dispositif suivant la revendication 1, caractérisé par le fait que le comparateur (9) est réalisé sous la forme d'un soustracteur comportant des première et seconde entrées, et que la première entrée (8a) est réalisée sous la forme d'une entrée inverseuse et dont la seconde entrée (8b) est réalisée sous la forme d'une entrée non inverseuse.

3. Dispositif suivant la revendication 1, caractérisé par le fait que le comparateur (9) est réalisé sous la forme d'un circuit additionneur et qu'un circuit inverseur (10) est disposé entre le circuit Sample & Hold (4) et le comparateur (9).

4. Dispositif suivant la revendication 1, caractérisé par le fait que le comparateur est réalisé sous la forme d'un circuit additionneur et qu'un circuit inverseur (10a) est disposé à l'entrée (5) du circuit Sample & Hold (4).

5. Dispositif suivant la revendication 3 ou 4, caractérisé par le fait que le circuit inverseur (10, 10a) est réalisé sous la forme d'un amplificateur.

6. Dispositif suivant l'une des revendications précédentes, caractérisé par le fait qu'entre la sortie (21) du comparateur (9) et une sortie de mesure (22), sur laquelle peut être prélevée la grandeur alternative reproduite, est disposé un filtre (12) qui est agencé sous la forme d'un filtre de blocage et d'un filtre passe-bas.

7. Dispositif suivant l'une des revendications précédentes, caractérisé par le fait que le comparateur (9) est réalisé sous la forme d'un amplificateur.

8. Dispositif suivant l'une des revendications 1 à 7, caractérisé par le fait que le composant à semiconducteurs (1) comprend au moins un thyristor.

9. Dispositif suivant la revendication 8, caractérisé par le fait que le composant à semiconducteurs (1) fait partie d'un circuit de réglage à thyristors (13).

**10.** Dispositif suivant l'une des revendications 6 à 9, caractérisé par le fait qu'à la sortie de mesure (22) est raccordé un dispositif de mesure (25,25a), qui indique une valeur d'intensité.

FIG 1

EP 0 343 392 B1

FIG 2